(19) Europäisches Patentamt
European Patent Office
Office européen des brevets

(11) EP 4 055 671 B1

(12) FASCICULE DE BREVET EUROPEEN

(45) Date de publication et mention de la délivrance du brevet:
**30.08.2023 Bulletin 2023/35**

(21) Numéro de dépôt: **20800160.2**

(22) Date de dépôt: **05.11.2020**

(51) Classification Internationale des Brevets (IPC):
*H01S 5/02* *(2006.01)*    *H01S 5/06* *(2006.01)*
*H01S 5/065* *(2006.01)*    *H01S 5/10* *(2021.01)*
*H01S 5/12* *(2021.01)*    *H01S 5/20* *(2006.01)*
*H01S 5/22* *(2006.01)*

(52) Classification Coopérative des Brevets (CPC):
**H01S 5/0651; H01S 5/021; H01S 5/0601;**
**H01S 5/0657; H01S 5/1003; H01S 5/101;**
**H01S 5/1032; H01S 5/12; H01S 5/1225;**
**H01S 5/2022; H01S 5/22**

(86) Numéro de dépôt international:
**PCT/EP2020/081104**

(87) Numéro de publication internationale:
**WO 2021/089687 (14.05.2021 Gazette 2021/19)**

(54) **LASER À VERROUILLAGE DE MODE À TRANCHÉES ET COMPOSANT OPTIQUE ASSOCIÉ**

MODENGEKOPPELTER LASER MIT GRÄBEN UND ZUGEHÖRIGE OPTISCHE KOMPONENTE

TRENCH-COMPRISING MODE-LOCKED LASER AND ASSOCIATED OPTICAL COMPONENT

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **07.11.2019 FR 1912503**

(43) Date de publication de la demande:
**14.09.2022 Bulletin 2022/37**

(73) Titulaires:
• **THALES**
**92400 Courbevoie (FR)**
• **Centre national de la recherche scientifique**
**75016 Paris (FR)**

(72) Inventeurs:
• **DE ROSSI, Alfredo**
**91767 Palaiseau Cedex (FR)**
• **COMBRIE, Sylvain**
**91767 Palaiseau Cedex (FR)**
• **BRETENAKER, Fabien**
**91405 Orsay Cedex (FR)**

(74) Mandataire: **Lavoix**
**2, place d'Estienne d'Orves**
**75441 Paris Cedex 09 (FR)**

(56) Documents cités:
**WO-A1-2015/099764**

• **C. T. SANTIS ET AL: "High-coherence semiconductor lasers based on integral high-Q resonators in hybrid Si/III-V platforms", PROCEEDINGS OF THE NATIONAL ACADEMY OF SCIENCES, vol. 111, no. 8, 10 février 2014 (2014-02-10), pages 2879-2884, XP055716859, ISSN: 0027-8424, DOI: 10.1073/pnas.1400184111 cité dans la demande**
• **BRIAN R KOCH ET AL: "Mode-locked silicon evanescent lasers", IEEE J. SEL. TOP. QUANTUM ELECTRON. IEEE MICROWAVE MAG. IEEE J. LIGHTWAVE TECHNOL. OPT. EXPRESS NATURE OPT. EXPRESS PROC. SPIE IEEE J. SEL. TOP. QUANTUM ELECTRON. APPL. PHYS. LETT. OPT. EXPRESS OPT. EXPRESS IEEE PHOTON. TECHNOL. LETT. APPL. OPT. E. (, vol. 1212500, no. 26, 1 janvier 2006 (2006-01-01), pages 1678-1687, XP055716112,**

- **KOCH B R ET AL: "A 40 GHz Mode Locked Silicon Evanescent Laser", 4TH IEEE INTERNATIONAL CONFERENCE ON GROUP IV PHOTONICS - 19-21 SEPT. 2007 - TOKYO, JAPAN, IEEE, US, 19 September 2007 (2007-09-19), pages 1-3, XP032144772, DOI: 10.1109/GROUP4.2007.4347655 ISBN: 978-1-4244-0934-1**

**Description**

La présente invention concerne un laser à verrouillage de mode, ainsi qu'un composant optique comprenant un tel laser.

L'invention se situe dans le domaine de la photonique intégrée, qui concerne la miniaturisation de composants optiques sur des circuits intégrés.

La photonique intégrée s'est développée sur des substrats comme le verre, le silicium ou les matériaux III-V. On utilise les matériaux III-V pour réaliser les sources laser semi-conducteur. On rappelle qu'un semi-conducteur de type « III - V » est un semi-conducteur composite fabriqué à partir d'un ou plusieurs éléments de la colonne III du tableau périodique des éléments (bore, aluminium, gallium, indium, ...) et d'un ou plusieurs éléments de la colonne V ou pnictogènes (azote, phosphore, arsenic, antimoine ...).

Il est souhaitable d'utiliser plutôt des substrats en silicium puisque les substrats en silicium permettent d'intégrer à la fois des composants optiques et des composants électroniques. Par ailleurs, ce choix permet l'utilisation d'une infrastructure existante qui est très performante pour la production industrielle.

Une source laser intégrée sur un circuit photonique présente généralement des dimensions micrométriques, c'est-à-dire dont les dimensions sont comprises entre un micron et un millimètre.

Notamment, de telles sources ont des applications notamment dans le domaine des télécommunications, où le débit de données est un paramètre qu'il est souhaitable d'améliorer, ainsi qu'en métrologie, où l'émission d'impulsions laser de courte durées et avec une haute fréquence de répétition permettent d'obtenir des précisions très élevées.

La miniaturisation des lasers à verrouillage de mode, typiquement en matériau III-V, et leur intégration sur puce photonique en silicium est un sujet de recherche appliquée très actif car il répond à un besoin important.

En effet, un laser à verrouillage de mode est propre à émettre des impulsions comprenant une pluralité de modes synchronisés en phase. Une telle source impulsionnelle à verrouillage de phase permet d'émettre des impulsions de très courte durée avec un très faible temps de répétition, afin d'atteindre des fréquences d'émission très élevées et donc des débits de données importants.

Une source laser à émission continue intégrée sur une puce photonique hybride, en matériau III-V sur silicium, est, par exemple, décrite dans l'article Santis, Christos Theodoros, et al., "High-coherence semiconductor lasers based on intégral high-Q resonators in hybrid Si/III-V platforms.", Proceedings of the National Academy of Sciences 111.8 (2014): 2879-2884.

La source laser décrite dans ce document comprend un support sur lequel s'étend une nervure constituée d'un empilement de couches successives de matériaux semi-conducteur de type III-V, ainsi qu'un guide d'ondes. La source fonctionne sur le principe de la cavité à rétroaction distribuée, qui met en oeuvre la réflexion des ondes sur un réseau de Bragg.

Cependant, la source décrite dans ce document ne donne pas entière satisfaction. En effet, cette source présente un unique mode propre de résonance, et ne permet pas l'émission d'impulsions laser multimodes synchronisées en phase.

Il existe donc un besoin pour la réalisation d'une source impulsionnelle à verrouillage de mode, intégrée sur une puce photonique et présentant une faible consommation énergétique.

A cet effet, il est proposé un laser à verrouillage de mode comprenant :

- un substrat isolant,
- une nervure s'étendant sur le substrat selon une direction d'étendue,
- une cavité résonante pour au moins une onde électromagnétique, la cavité étant définie dans le substrat, au droit de la nervure,
- un guide d'ondes défini dans le substrat, s'étendant selon une direction de guidage,

    la nervure comprenant une couche inférieure, une pluralité de couches intermédiaires et une couche supérieure, empilées selon une direction d'empilement orthogonale à la direction d'étendue,

    la cavité étant propre à accueillir une pluralité de modes de résonnance équidistants en fréquence,

    la cavité comprenant une pluralité de tranchées ménagées dans au moins une des faces de la cavité, les tranchées s'étendant perpendiculairement à la direction d'étendue,

    chaque tranchée présentant des paramètres, les paramètres étant :

    - une largeur de la tranchée, mesurée selon une direction transversale orthogonale à la direction d'étendue et à la direction d'empilement,
    - une épaisseur de la tranchée, mesurée selon la direction d'étendue,
    - une profondeur de la tranchée, mesurée selon la direction d'empilement, et
    - une dimension d'un écartement séparant chaque tranchée d'une tranchée voisine, la dimension étant mesurée selon la direction d'étendue,

    au moins un paramètre parmi les paramètres des tranchées variant selon la direction d'étendue selon une loi de variation, la loi de variation étant une fonction polynomiale symétrique d'ordre supérieur ou égal à 4 d'une position de la tranchée selon la direction d'étendue.

Selon des modes de réalisation particuliers, le laser présente l'une ou plusieurs des caractéristiques suivantes, prise(s) isolément ou selon toute combinaison techniquement réalisable :

- la fonction polynomiale est d'ordre quatre, et est décrite par une formule du type :

$$p_n = p(x_n) = p_0 + A x_n^2 + B x_n^4$$

où :

  - $p_n$ est la valeur du paramètre de la tranchée référencée par un indice n,
  - $x_n$ est la distance entre une tranchée, référencée par l'indice 0, et la tranchée référencée par l'indice n,
  - $p_0$ est la valeur du paramètre de la tranchée référencée par l'indice 0, et
  - A et B sont des constantes non-nulles,

- une valeur de A est choisie de manière à fixer une valeur d'un intervalle spectral libre de la cavité, une valeur de B étant choisie pour permettre d'obtenir les modes de résonance équidistants en fréquence de la cavité,
- la cavité présente une longueur mesurée selon la direction d'étendue, la longueur de la cavité étant suffisante pour que la cavité soit apte à accueillir au moins six modes de résonnance équidistants en fréquence, la longueur de la cavité étant notamment supérieure ou égale à 200 micromètres,
- la couche inférieure définit, selon une direction transversale, des prolongements latéraux s'étendant de part et d'autre des couches intermédiaires et de la couche supérieure, chaque prolongement latéral recevant au moins un contact électrique,
- la couche supérieure comprend un sillon isolant s'étendant à travers la couche supérieure selon la direction transversale, de manière à diviser la couche supérieure en deux régions voisines selon la direction d'étendue, isolées électriquement l'une de l'autre, chaque région recevant un contact électrique respectif distinct,
- la nervure comprend également une couche absorbante s'étendant en-dessous de la couche inférieure selon la direction d'empilement, la couche absorbante comprenant un matériau absorbant saturable à au moins une fréquence de résonance de la cavité,
- le guide d'ondes est décalé par rapport à la cavité et à la nervure, selon la direction transversale, et
- le guide d'ondes présente une largeur variable le long d'une étendue du guide d'onde, mesurée selon une direction orthogonale à une direction d'étendue locale du guide d'onde.

La présente description concerne également un composant optique comprenant un laser tel que précédemment décrit.

L'invention sera mieux comprise à la lecture de la description qui suit, donnée uniquement à titre d'exemple et faite en référence aux dessins annexés, parmi lesquels :

- [Fig 1] la figure 1 est une vue en perspective schématique simplifiée d'un exemple de laser;
- [Fig 2] la figure 2 est une vue en coupe transversale du laser de la figure 1 ;
- [Fig 3] la figure 3 est une vue en coupe longitudinale du laser de la figure 1 ;
- [Fig 4] la figure 4 est une vue en coupe horizontale du laser de la figure 1 ; et
- [Fig 5] la figure 5 est une vue de coupe transversale d'un autre exemple de laser.

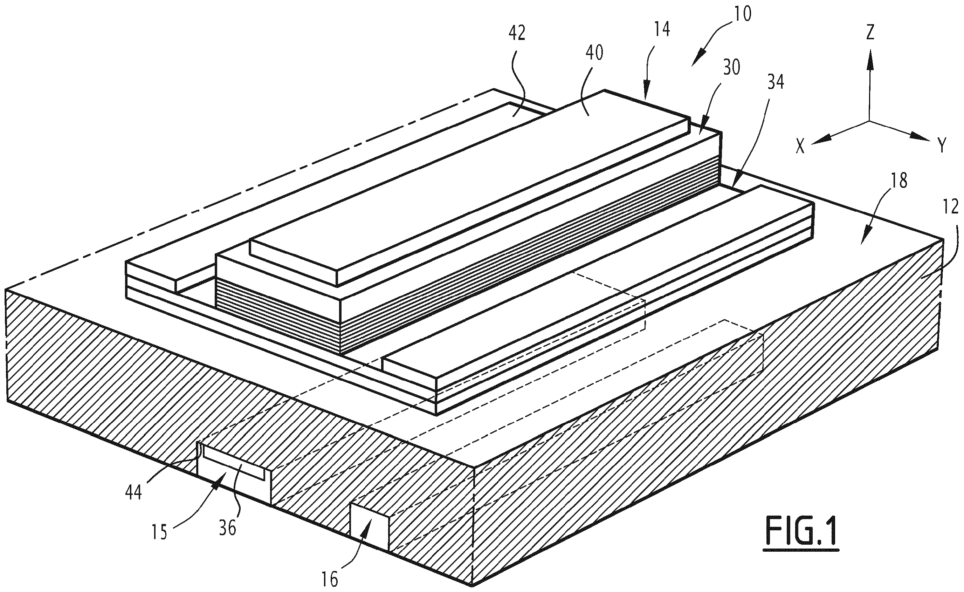

Un laser 10 est représenté sur les figures 1 à 4.

Par le terme « laser », il est entendu un système photonique qui produit un rayonnement lumineux spatialement et temporellement cohérent basé sur l'effet laser (acronyme issu de l'anglais light *amplification by stimulated émission of radiation* qui signifie « amplification de la lumière par émission stimulée de radiation »).

Une source laser associe un amplificateur optique à une cavité optique dans laquelle le rayonnement lumineux est partiellement confiné, encore appelée résonateur. A chaque parcours de la cavité par le rayonnement lumineux, une partie de la lumière sort de la cavité et l'autre partie est réinjectée vers l'intérieur de la cavité et l'amplificateur pour être amplifiée.

Le laser 10 est un laser à verrouillage de mode, c'est-à-dire apte à émettre des ondes électromagnétiques formant des impulsions laser cohérentes synchronisées en phase.

Le laser 10 est, de plus, apte à émettre des impulsions laser multimodes, c'est-à-dire des ondes impulsionnelles présentant un grand nombre de modes équi-espacés en fréquence optique, dans une bande de fréquence d'intérêt.

Le laser 10 comprend un substrat 12, une nervure 14, une cavité 15 et un guide d'ondes 16.

La laser 10 est décrit en référence à une direction d'étendue X, une direction transversale Y et une direction d'empilement Z, orthogonales les unes aux autres.

Dans tout ce qui suit, par l'expression « compris entre deux valeurs », il est entendu un encadrement au sens large, c'est-à-dire incluant les valeurs des bornes.

Le substrat 12 est une couche formant une plaque. Le substrat 12 est réalisé en matériau isolant électriquement, et ne conduit donc pas le courant électrique.

Selon l'exemple représenté, le matériau isolant électriquement est un oxyde de silicium.

Le matériau isolant composant le substrat 12 est perméable au rayonnement lumineux, et présente un indice de réfraction.

L'indice de réfraction du matériau isolant est, par exemple, compris entre 1,3 et 1,7.

Le substrat 12 présente une face supérieure 18 s'étendant dans un plan horizontal XY.

La face supérieure 18 est la limite supérieure d'une couche constituée par le substrat 12.

Le substrat 12 porte la nervure 14 sur la face supérieure 18.

La cavité 15 et le guide d'ondes 16 s'étendent dans le substrat 12, à l'écart de la face supérieure 18. La cavité 15 et le guide d'ondes 16 sont donc enfouis dans le substrat 12.

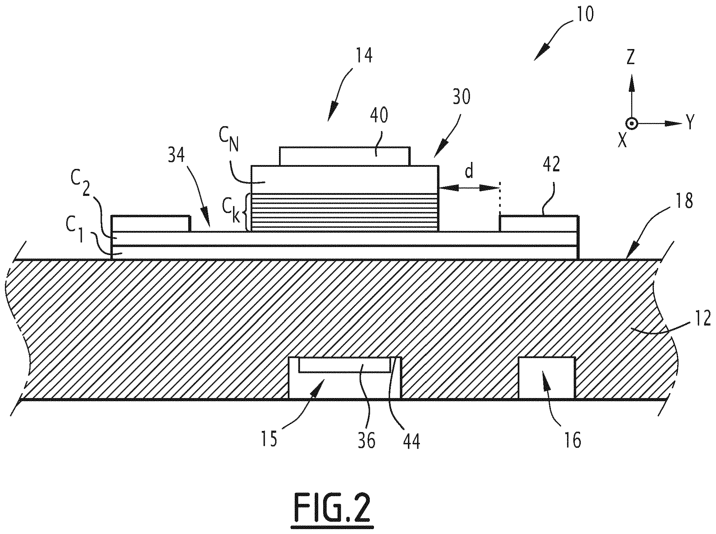

Comme représenté sur la figure 2, la nervure 14 est une structure multicouche en contact avec la face supérieure 18 du substrat 12. Autrement dit, la nervure 14 comprend une pluralité de couches planaires et superposées, qui reposent sur le substrat 12.

Dans l'exemple présenté, la nervure 14 comprend N couches $C_k$ superposées, l'indice k variant de 1 à N.

Les couches $C_k$ sont empilées suivant la direction d'empilement Z.

La couche $C_1$ portant l'indice k = 1 est la couche s'étendant sur la face supérieure 18 du substrat 12.

L'indice k augmente d'une couche $C_k$ à la suivante $C_{k+1}$ selon la direction d'empilement Z.

Chaque couche $C_k$ présente une épaisseur $e_k$, mesurée selon la direction d'empilement Z.

Chaque couche $C_k$ est réalisée à partir d'un matériau $M_k$.

La couche $C_1$ est une couche absorbante.

L'épaisseur $e_1$ est comprise entre 5 nanomètres et 10 nanomètres.

Le matériau $M_1$ est un matériau absorbant saturable, c'est-à-dire un matériau dont le coefficient d'absorption d'une onde électromagnétique qui le traverse décroit quand l'intensité de l'onde augmente, au moins pour des fréquences de la plage de fréquences d'intérêt.

Le matériau $M_1$ est, par exemple, le graphène.

Selon un mode de réalisation, le matériau $M_1$ est un matériau semi-conducteur de type III-V, comme défini précédemment.

Par exemple, le matériau $M_1$ est le l'arséniure phosphure de gallium d'indium, aussi noté InGaAsP ou l'arséniure de gallium d'indium, aussi noté InGaAs, avec une composition d'alliage ajustées pour avoir une absorption satisfaisante sur la plage de fréquences d'intérêt.

La couche $C_2$ est une couche inférieure, dopée de type P.

L'épaisseur $e_2$ est comprise entre 50 et 250 nanomètres, de préférence entre 100 et 150 nanomètres, par exemple égale à 130 nanomètres.

Le matériau $M_2$ est un matériau semi-conducteur de type III-V, comme défini précédemment.

Par exemple, le matériau $M_2$ est l'arséniure phosphure de gallium d'indium, InGaAsP.

Le matériau $M_2$ comprend entre 0% et 40% de gallium et entre 60% et 100% d'indium, par exemple 20% de gallium et 80% d'indium, en masse, relativement à la masse totale de gallium et d'indium.

Le matériau $M_2$ comprend également entre 0% et 60% de phosphore et entre 40% et 100% d'arsenic, par exemple 55% de phosphore et 45% d'arsenic, en masse, relativement à la masse totale de phosphore et d'arsenic.

Par « dopée de type P », il est entendu que la couche $C_2$ comprend des impuretés électropositives ajoutées en petite quantité dans le matériau $M_2$.

Par le terme « électropositives », il est entendu que les impuretés induisent un déficit d'électrons dans la couche $C_2$.

Par exemple, les impuretés électropositives sont des atomes de zinc, introduits avec une proportion volumique de l'ordre de $10^{18}$ atomes/cm$^3$.

La couche $C_N$ est une couche supérieure.

La couche $C_N$ est dopée de type N.

L'épaisseur $e_N$ est comprise entre 50 nanomètres et 250 nanomètres, de préférence entre 100 nanomètres et 150 nanomètres, par exemple égale à 150 nanomètres.

Le matériau $M_N$ est un matériau semi-conducteur de type III-V.

Par exemple, le matériau $M_N$ est le phosphure d'indium, aussi noté InP.

Par « dopée de type N », il est entendu que la couche $C_N$ comprend des impuretés électronégatives ajoutées en petite quantité dans le matériau $M_N$.

Par le terme « électronégatives », il est entendu que les impuretés induisent un excès d'électrons dans la couche $C_N$.

Par exemple, les impuretés électronégatives sont des atomes de silicium, introduits avec une proportion volumique de l'ordre de $10^{18}$ atomes/cm$^3$.

Les couches $C_3$ à $C_{N-1}$ sont des couches intermédiaires.

Parmi les couches intermédiaires, la couche $C_3$ est une première couche intrinsèque et la couche $C_{N-1}$ est une deuxième couche intrinsèque.

Par le terme « instrinsèque », il est entendu que les couches $C_3$ et $C_{N-1}$ sont des couches non-dopées, voisines de couches dopées de type P et N respectivement.

L'épaisseur $e_3$ et l'épaisseur $e_{N-1}$ sont comprises entre 15 nanomètres et 100 nanomètres, de préférence entre 15 nanomètres et 60 nanomètres, par exemple égales à 40 nanomètres.

Le matériau $M_3$ et le matériau $M_{N-1}$ sont des matériaux semi-conducteurs de type III-V.

Le matériau $M_3$ et le matériau $M_{N-1}$ sont, par exemple, de l'arséniure phosphure de gallium d'indium, InGaAsP.

Le matériau $M_3$ et le matériau $M_{N-1}$ comprennent entre 0% et 40% de gallium et entre 60% et 100% d'indium, par exemple 16% de gallium et 84% d'indium, en masse, relativement à la masse totale de gallium et

Le matériau $M_3$ et le matériau $M_{N-1}$ comprennent également entre 0% et 60% de phosphore et entre 40% et 100% d'arsenic, par exemple 52% de phosphore et 48% d'arsenic, en masse, relativement à la masse totale de phosphore et d'arsenic.

Les couches $C_4$ à $C_{N-2}$ sont des couches médianes.

Les couches médianes comprennent des couches d'indice pair $C_{2i}$ identiques entre elles et des couches d'indice impair $C_{2i+1}$ identiques entre elles.

Les épaisseurs $e_{2i}$ sont comprises entre 4 nanomètres et 12 nanomètres, par exemple égales à 6,5 nanomètres.

Les épaisseurs $e_{2i+1}$ sont comprises entre 10 nanomètres et 50 nanomètres, de préférence entre 10 nanomètres et 20 nanomètres, par exemple égales à 15 nanomètres.

Les matériaux $M_{2i}$ et $M_{2i+1}$ des couches médianes sont des matériaux semi-conducteurs de type III-V.

Les matériaux $M_{2i}$ et $M_{2i+1}$ sont choisis de façon à ce que les couches d'indice pair $C_{2i}$ forment des puits quantiques.

Par le terme « puits quantiques », on désigne des zones de faible dimension dans une structure hétérogène d'un semi-conducteur présentant un potentiel plus faible, pour confiner les électrons. Le mouvement des électrons est alors discrétisé dans la direction d'empilement Z, ce qui permet l'apparition de bandes d'énergie.

Le matériaux $M_{2i}$ est, par exemple, l'arséniure phosphure de gallium d'indium, InGaAsP.

Le matériau $M_{2i}$ comprend entre 0% et 40% de gallium et entre 60% et 100% d'indium, par exemple 16% de gallium et 84% d'indium, en masse, relativement à la masse totale de gallium et d'indium.

Le matériau $M_{2i}$ comprend également entre 0% et 30% de phosphore et entre 70% et 100% d'arsenic, par exemple 24% de phosphore et 76% d'arsenic, en masse, relativement à la masse totale de phosphore et d'arsenic.

Le matériau $M_{2i+1}$ est, par exemple, également l'arséniure phosphure de gallium d'indium, InGaAsP, avec une composition différente de celle du matériau $M_{2i}$.

Le matériau $M_{2i+1}$ comprend entre 5% et 40% de gallium et entre 60% et 95% d'indium, par exemple 16% de gallium et 84% d'indium, en masse, relativement à la masse totale de gallium et d'indium.

Le matériau $M_{2i+1}$ comprend également entre 0% et 60% de phosphore et entre 40% et 100% d'arsenic, par exemple 52% de phosphore et 48% d'arsenic, en masse, relativement à la masse totale de phosphore et d'arsenic.

Les matériaux $M_k$ composant la nervure 14 sont perméables au rayonnement lumineux, et présentent des indices de réfraction respectifs.

Les indices de réfraction des matériaux de la nervure 14 sont, par exemple, supérieurs à 3.

La nervure 14 comprend une partie centrale 30, deux prolongements latéraux 34 et un contact supérieur 40.

La nervure 14 est agencée pour former un guide optique dans lequel se propage au moins une onde électromagnétique présentant des fréquences parmi une plage de fréquences d'intérêt.

La nervure 14 présente un gain d'intensité pour certaines fréquences de l'onde.

La partie centrale 30 est une partie rectiligne s'étendant selon la direction d'étendue X.

Ainsi, la partie centrale 30 présente une forme parallélépipédique, allongée selon la direction d'étendue X.

La partie centrale 30 comprend un contact supérieur 40, s'étendant sur la couche $C_N$.

Le contact supérieur 40 est une métallisation destinée à recevoir une électrode afin de la porter à un premier potentiel électrique et de faire circuler un courant électrique dans la nervure 14.

Le contact supérieur 40 est, par exemple, de forme rectangulaire.

Le contact supérieur 40 présente une largeur, mesurée selon la direction transversale Y, supérieure à la largeur de la partie centrale 30.

Cela permet notamment de diminuer la résistance électrique du contact supérieur 40.

Le contact supérieur 40 est réalisé en un premier matériau métallique.

Le premier matériau métallique est, par exemple, l'or ou le titane.

Les prolongements latéraux 34 sont des extensions de la couche inférieure $C_2$ sur la face supérieure 18 du substrat 12.

Les prolongements latéraux 34 font saillie depuis la partie centrale 30 et s'étendent de part et d'autre de la partie centrale 30 selon la direction transversale Y.

Les prolongements latéraux 34 présentent chacun une forme rectangulaire aplatie dans un plan horizontal XY.

La couche inférieure $C_2$ s'étend sur le substrat 18 depuis la partie centrale pour former les prolongements latéraux 34.

Chaque prolongement latéral 34 comprend un contact latéral 42 sur une face supérieure.

Chaque prolongement latéral 34 a une épaisseur mesurée selon la direction d'empilement Z.

L'épaisseur de chaque prolongement latéral 34 est inférieure à l'épaisseur $e_2$.

Par exemple, l'épaisseur des prolongements latéraux 34 est comprise entre deux tiers et la moitié de $e_2$.

Les contacts latéraux 42 sont des sites de réception d'une électrode, destinée à porter le contact latéral 42 à un deuxième potentiel électrique différent du premier potentiel électrique, afin de faire circuler un courant électrique dans la nervure 14.

Les contacts latéraux 42 sont symétriques l'un à l'autre par rapport à la partie centrale 30 de la nervure 14.

Les contacts latéraux 42 sont réalisés en un deuxième matériau métallique.

Le deuxième matériau métallique est, par exemple, l'or ou le zinc.

Chaque contact latéral 42 est séparé de la partie centrale 30 de la nervure par une distance d.

La distance d est mesurée selon la direction transversale Y, entre les points les plus proches du contact latéral 42 et de la partie centrale 30, comme représenté sur la figure 2.

La distance d est choisie pour minimiser une absorption dans les contacts latéraux 42 d'une onde électromagnétique se propageant dans la nervure 14, tout en maintenant une conduction suffisamment élevée entre les contacts latéraux 42 et la partie centrale 30.

La distance d est, par exemple, comprise entre 0,5 fois et 2 fois la longueur d'onde d'une onde de fréquence appartenant à la plage de fréquences d'intérêt, divisée par l'indice de réfraction du deuxième matériau métallique.

La cavité 15 est une chambre de résonnance conductrice pour les ondes électromagnétiques.

La cavité 15 s'étend dans le substrat 12 isolant.

La cavité 15 présente une forme parallélépipédique allongée selon la direction d'étendue X.

La cavité 15 présente une longueur $L_c$, mesurée selon la direction d'étendue X, une largeur $W_c$, mesurée selon la direction transversale Y et une hauteur $H_c$, mesurée selon la direction d'empilement Z.

La longueur $L_c$ de la cavité 15 est suffisante pour que la cavité 15 puisse accueillir un nombre prédéterminé de modes de résonance, dont un mode fondamental présentant une largeur à mi-hauteur.

Par le terme « largeur à mi-hauteur », il est entendu, pour une variable dépendante qui varie selon une variable indépendante, suivant une courbe présentant une valeur maximale, la différence entre les deux valeurs extrêmes de la variable indépendante pour lesquelles la variable dépendante est égale à la moitié de la valeur maximale.

Dans le cas présent, la variable indépendante est une fréquence d'une onde électromagnétique et la variable dépendante une intensité de l'onde électromagnétique à cette fréquence.

Par exemple, la cavité 15 est adaptée pour accueillir au moins six modes de résonance, notamment huit modes de résonance, autour d'un mode fondamental pour lequel la largeur à mi-hauteur est égale à 50 micromètres.

Dans ce cas, la longueur $L_c$ de la cavité 15 est supérieure ou égale à 200 micromètres, notamment supérieure ou égale à 500 micromètres.

La longueur $L_c$ est, par exemple, comprise entre 500 micromètres et 2000 micromètres.

La largeur $W_c$ est, par exemple, comprise entre 800 nanomètres et 2000 nanomètres.

La hauteur $H_c$ est, par exemple, comprise entre 200 nanomètres et 800 nanomètres.

La cavité 15 est réalisée avec un matériau perméable au rayonnement lumineux.

Le matériau composant la cavité 15 présente un indice de réfraction.

L'indice de réfraction du matériau de cavité 15 est, par exemple, supérieur à 3.

Le matériau composant la cavité 15 est, par exemple, le silicium.

La cavité 15 comprend une pluralité de tranchées 36 s'étendant sur au moins une face de la cavité 15.

Dans l'exemple présenté, les tranchées 36 s'étendent sur une face supérieure 44 de la cavité 15. La face supérieure 44 est la face de la cavité 15 faisant face à la nervure 14.

La cavité est séparée de la nervure 14 par une distance Δ.

La distance Δ est mesurée entre la face supérieure 44 de la cavité 15 et la face supérieure 18 du substrat 12.

La distance Δ est, par exemple, constante sur toute l'étendue de la cavité 15.

La distance Δ est, par exemple, comprise entre 100 nanomètres et 500 nanomètres.

Les tranchées 36 sont des reliefs allongés définis dans la cavité 15.

Les tranchées 36 sont parallèles les unes aux autres et perpendiculaires à la direction d'étendue X.

Selon l'exemple représenté, les tranchées 36 présentent des formes allongées selon la direction transversale Y.

Chaque tranchée 36 présente un plan médian orthogonal à la direction d'étendue X.

Les tranchées 36 sont alignées le long de la cavité 15 selon la direction d'étendue X de manière à former un réseau partiellement réfléchissant pour les ondes électromagnétiques, connu sous le nom de réseau de Bragg.

Les tranchées 36 sont référencées ci-après par un indice n, à partir d'une première tranchée 36 portant l'indice n = 0, choisie à une extrémité de la cavité 15.

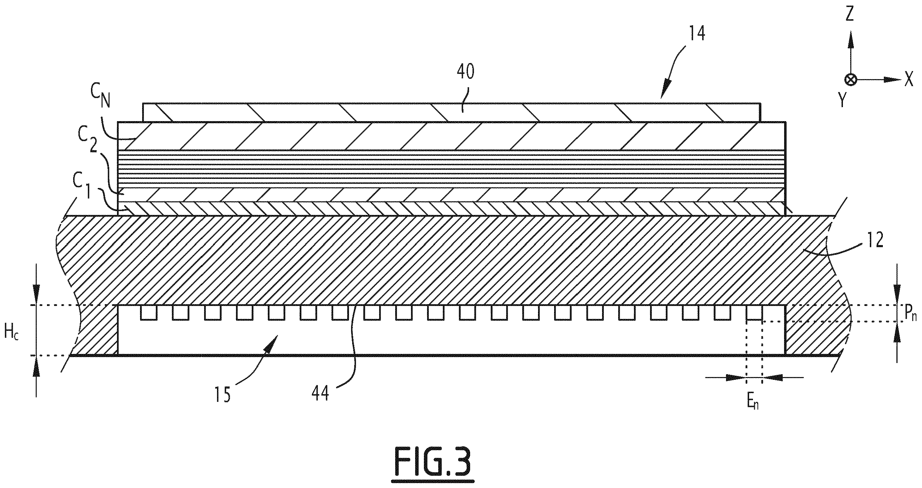

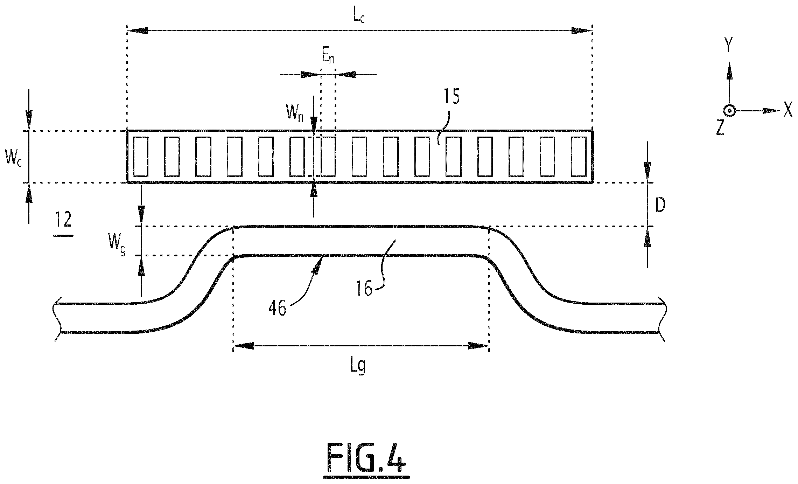

Chaque tranchée 36 présente une épaisseur $E_n$, mesurée selon la direction d'étendue X, comme représenté sur la figure 3 et sur la figure 4.

Chaque tranchée 36 présente une profondeur $P_n$, mesurée selon la direction d'empilement Z, comme représenté sur la figure 3.

Chaque tranchée 36 présente une largeur $W_n$, mesurée selon la direction transversale Y, comme représenté sur la figure 4.

Chaque tranchée 36 d'indice n est séparée de la tranchée suivante d'indice n+1 par un écartement, correspondant à une période locale du réseau de tranchées 36.

Une dimension de l'écartement séparant la tranchée 36 d'indice n de la tranchée 36 d'indice n+1, mesurée selon la direction d'étendue X, est notée $a_n$.

La dimension $a_n$ de l'écartement séparant deux tranchées 36 est mesurée entre les deux bords les plus proches des deux tranchées 36.

Les épaisseurs $E_n$, les profondeur $P_n$ et les largeurs $W_n$ des tranchées 36, ainsi que les dimensions des écartements séparant les tranchées constituent des paramètres du réseau de tranchées 36.

Au moins un des paramètres, choisi parmi les épaisseurs $E_n$, les profondeurs $P_n$, les largeurs $W_n$ et les dimensions $a_n$ des écartements, varie d'une tranchée d'indice n à la tranchée suivante d'indice n+1, selon une loi de variation.

Ainsi, au moins l'un des paramètres est choisi pour varier selon la direction d'étendue X, d'une tranchée 36 à la suivante, les autres paramètres non choisis restant constants sur toutes les tranchées 36.

Dans l'exemple présenté, la dimension $a_n$ varie d'un écartement à l'autre selon la loi de variation.

Les autres paramètres $E_n$, $P_n$ et $W_n$ sont constants d'une tranchée à l'autre.

La valeur de $P_n$ est, par exemple, comprise entre 30 nanomètres et 100 nanomètres.

La valeur de $W_n$ est, par exemple, comprise entre 20% et 90% de la largeur Wg de la cavité 15.

La hauteur $E_n$ est, par exemple, comprise entre 30% et 70% de la dimension $a_n$ de l'écartement.

La loi de variation de la dimension $a_n$ selon la direction d'étendue X est choisie pour permettre le verrouillage de modes par le laser 10, c'est-à-dire pour que la cavité 15 présente plusieurs modes de résonance équi-espacés en fréquence.

La loi de variation est une fonction dont une variable est la position $x_n$ des tranchées 36.

La position $x_n$ d'une tranchée 36 d'indice n est la distance séparant le plan médian de la tranchée 36 d'indice n du plan médian de la tranchée 36 d'indice 0.

La loi de variation est, par exemple, une fonction polynomiale.

Par exemple, la loi de variation est une fonction polynomiale symétrique, d'ordre au moins égal à 4.

Par le terme « symétrique », il est entendu que les termes d'ordre impair de la fonction polynomiale sont nuls.

Ainsi, une loi de variation envisageable est du type :

$$a_n = a(x_n) = a_0 + \alpha x_n{}^2 + \beta x_n{}^4 + \ ...$$

Où $a_0$ est la dimension de l'écartement séparant la tranchée 36 d'indice 0 de la tranchée 36 d'indice 1, et $\alpha$ et $\beta$ sont des constantes non nulles.

Selon l'exemple proposé, la loi de variation est une fonction polynomiale symétrique d'ordre 4.

Selon l'exemple proposé, la loi de variation s'exprime sous la forme :

$$a_n = a(x_n) = a_0 + Ax_n{}^2 + Bx_n{}^4$$

Où $a_0$ est la dimension de l'écartement séparant la tranchée 36 d'indice 0 de la tranchée 36 d'indice 1, et où A et B sont des constantes non nulles.

Les valeurs des constantes A et B sont choisies pour obtenir l'émission par le laser 10 d'une onde électromagnétique présentant des modes équi-espacés en fréquence.

Plus précisément, la valeur de A est choisie de manière à fixer une valeur d'un intervalle spectral libre de la cavité 15.

La valeur de B est choisie pour permettre d'obtenir les modes de résonance équidistants en fréquence de la cavité 15.

Les valeurs de $a_0$, A et B sont, par exemple, obtenues par une simulation numérique du fonctionnement du laser 10.

La valeur de $a_0$ est proche de la valeur dictée par l'équation: $\lambda/(2*n_{eff})$, où $\lambda$ est la longueur d'onde d'émission du laser 10 et $n_{eff}$ l'indice effectif du mode guidé dans la cavité 15.

Par, exemple, $n_{eff}$ est égal à 2,7 et $\lambda$ est égale à 1550 nanomètres.

La valeur de $a_0$ est donc proche de 290 nanomètres.

Par exemple, la valeur de $a_0$ est comprise entre 200 nanomètres et 400 nanomètres, plus particulièrement entre 260 nanomètres et 330 nanomètres.

Selon l'exemple représenté, la valeur de $a_0$ est choisie égale à 290 nanomètres.

Par exemple, la valeur de A est choisie entre $1 \times 10^{-3}$ mètres$^{-1}$ et $1 \times 10^{-2}$ mètres$^{-1}$.

Selon l'exemple représenté, la valeur de A est choisie égale à $2,2 \times 10^{-3}$ mètres$^{-1}$.

Par exemple, la valeur de B est choisie entre $2 \times 10^3$ mètres$^{-3}$ et $4 \times 10^4$ mètres$^{-3}$.

Selon l'exemple représenté, la valeur de B est choisie égale à $1 \times 10^4$ mètres$^{-3}$.

Dans l'exemple présenté, avec les valeurs de $a_0$, A et B choisies, la variation de $a_n$ est approximativement de 0,1% du centre de la cavité 15 aux extrémités de la cavité 15.

Les valeurs de A et de B de l'exemple présenté ont été testées expérimentalement et permettent l'émission par le laser 10 d'impulsions multimodes verrouillées en phase.

Plus généralement, la cavité 15 est adaptée pour accueillir un nombre $N_m$ de modes de résonance, autour d'un mode fondamental pour lequel la largeur à mi-hauteur est notée $X_0$.

La longueur $L_c$ minimale de la cavité 15 est donnée par l'équation :

$$L_c = 2X_0\sqrt{N_m}$$

dans laquelle $X_0$ est obtenue par l'équation :

$$X_0 = \sqrt{\frac{2V_g^2}{\Delta\omega_g * \Omega}}$$

où :

$V_g$ est la vitesse de groupe des ondes électromagnétiques dans la structure,

$\Delta\omega_g$ est la largeur spectrale de la réflectivité de la structure, et

$\Omega$ est l'écart spectral entre chacun des modes.

Par le terme « vitesse de groupe », il est entendu, pour une superposition d'ondes électromagnétiques, une vitesse de transmission d'un signal par la superposition de ces ondes.

$V_g$ est égale à la célérité de la lumière dans le vide, divisée par l'indice de réfraction du matériau composant la cavité 15.

Par le terme « largeur spectrale de la réflectivité », il est entendu la largeur à mi-hauteur de la courbe représentant la réflectivité du réseau formé par les tranchées en fonction de la fréquence.

La réflectivité est le carré du rapport des amplitudes de l'onde réfléchie par une structure et de l'onde incidente sur la structure à une fréquence donnée.

$\Delta\omega_g$ est, dans l'exemple proposé, égale à $\pi \times 10^{12}$ hertz.

Par le terme « écart spectral entre les modes », il est entendu un écart de fréquence entre les fréquences pour lesquelles l'amplitude est maximale, pour deux modes successifs de la cavité.

$\Omega$ est, dans l'exemple représenté, égal à $2\pi \times 150$ gigahertz.

Le guide d'ondes 16 est un canal conducteur s'étendant à travers le substrat 12.

Le guide d'ondes 16 est propre à recueillir une partie de l'onde électromagnétique se propageant dans la cavité 15, sous la forme d'ondes évanescentes traversant le substrat 12.

Le guide d'ondes 16 s'étend à une distance non nulle de la face supérieure 18 du substrat 12.

Le guide d'ondes 16 présente une section rectangulaire dans un plan orthogonal à sa direction d'étendue locale.

Le guide d'ondes 16 est réalisé, par exemple, en silicium.

Le guide d'ondes 16 est décalé selon la direction transversale Y par rapport à la nervure 14 et à la cavité 15.

La distance séparant le guide d'ondes 16 de cavité 15, mesurée selon la direction transversale Y, varie le long du guide d'onde 16.

Selon l'exemple présenté, comme visible sur la figure 4, le guide d'onde 16 s'étend selon une courbe et comprend un segment proximal 46, relativement à la cavité 15.

Le segment proximal 46 est rectiligne et s'étend parallèlement à la cavité 15.

Le segment proximal 46 s'étend à une distance D de la cavité 15.

La distance D est mesurée entre les faces les plus proches du segment proximal 46 et de la cavité 15, comme représenté sur la figure 4.

La distance D est suffisamment faible pour qu'une partie de l'onde électromagnétique se propageant dans la cavité 15 soit captée par le guide d'ondes 16 sous forme d'onde évanescente, à travers le substrat 12 isolant.

Le guide d'ondes 16 est également propre à guider l'onde électromagnétique recueillie à l'écart de la nervure 14.

Le fonctionnement du laser 10 va maintenant être décrit.

Un même premier potentiel électrique est appliqué aux contacts latéraux 42 et un deuxième potentiel électrique est appliqué au contact supérieur 40, de façon à faire circuler un courant électrique des contacts latéraux 42 au contact supérieur 40.

Le courant traverse la couche $C_2$, dopée P, puis parcourt la nervure 14 selon la direction d'empilement Z jusqu'à la couche $C_N$, dopée N.

Une onde électromagnétique se propage dans la cavité 15, et s'étale et pénètre dans la nervure 14, en particulier dans les puits quantiques formés par les couches $C_{2i}$ de la nervure 14.

La différence d'indice de réfraction entre les matériaux composant la nervure 14 et la cavité 15 et le matériau isolant composant le substrat 12 permet le confinement du rayonnement lumineux dans la nervure 14 et la cavité 15.

Un pompage optique électrique a lieu au sein des puits quantiques, ce qui permet d'obtenir une amplification laser de certaines fréquences de l'onde électromagnétique se propageant dans la nervure 14, dans la bande de fréquence d'intérêt.

La répartition des tranchées 36 sur la face supérieure 44 de la cavité 15 permet de sélectionner les fréquences réfléchies vers la nervure, qui y sont amplifiées.

La couche absorbante $C_1$ absorbe les parties de l'onde électromagnétique dont l'intensité est faible, c'est-à-dire les fréquences faiblement réfléchies par le réseau de tranchées 36.

Les fréquences désirées de l'onde électromagnétique se propageant dans la nervure 14 sont ainsi amplifiées par un effet de cascade, ce qui permet d'obtenir une onde électromagnétique présentant une pluralité de modes equi-espacés en fréquence.

Une partie de l'onde électromagnétique se propageant dans la cavité 15 traverse le substrat 12 sous forme d'onde évanescente pour rejoindre le guide d'ondes 16, puis est guidée par le guide d'ondes 16 à l'écart de la nervure 14.

Le laser 10 décrit est apte à émettre des impulsions laser multimodes synchronisées en phase, tout en présentant une structure fortement miniaturisée.

Cela permet d'avoir une bonne intégration du laser 10 sur une structure en silicium en présentant un encombrement très réduit. De plus, la miniaturisation du laser 10 permet d'avoir une consommation énergétique très faible, ce qui est un avantage important en optique intégrée.

Les impulsions laser comprennent plusieurs modes équi-espacés en fréquence avec une grande précision et une bonne régularité. Ces caractéristiques sont très avantageuses en métrologie par exemple.

Cela permet au laser 10 d'émettre un train d'impulsions gaussiennes proches de la gaussienne idéale, avec des taux de répétition supérieurs à 10 GHz, ce qui permet, par exemple, d'obtenir des débits de données importants pour des communications optiques sur puce. Notamment, selon la géométrie choisie, il est possible d'obtenir un taux de répétition compris entre 40 GHz et 100 GHz.

La couche absorbante permet au laser 10 de se verrouiller de manière passive. Le verrouillage du laser 10 est robuste et peu sensible aux effets de bord.

Le guide d'onde 16 décalé par rapport à la nervure 14 et couplé à la cavité 15 selon la direction transversale Y permet d'optimiser le couplage aux différents modes de la cavité 15.

En outre, le laser 10 est aisé à fabriquer, en particulier par une technique de dépôt de couches minces pour la partie en matériau III-V et par une technique de lithographie électronique et de gravure sèche pour la partie en silicium. La jonction des deux parties se fait par collage moléculaire ou adhésif.

Le procédé de fabrication est identique à celui des dispositifs décrits dans l'article de Duan, Guang-Hua, et al., intitulé « *Hybrid III--V on Silicon Lasers for Photonic Integrated Circuits on Silicon* », tiré du journal IEEE Journal of selected topics in quantum electronics 20.4 (2014): 158-170.

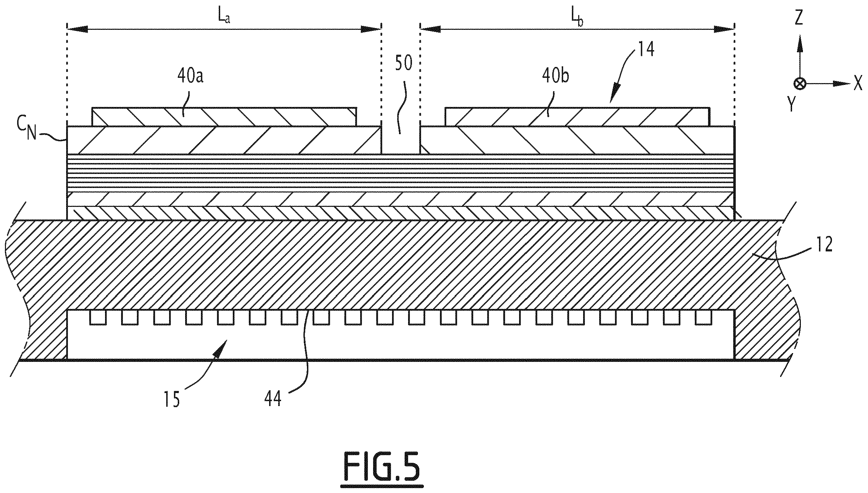

Un laser 10 est représenté sur la figure 5.

Le laser 10 présente une structure et un fonctionnement similaire au laser 10 décrit précédemment, à l'exception de ce qui suit.

La nervure 14 du laser 10 ne comprend pas de couche absorbante.

La couche inférieure s'étend directement sur la face supérieure 18 du substrat 12.

Le laser 10 comprend un sillon 50 s'étendant selon la direction transversale Y, à travers la couche $C_N$, et divisant la couche $C_N$.

Le sillon 50 est un segment isolant, traversant toute l'épaisseur de la couche $C_N$ jusqu'à la couche $C_{N-1}$.

La couche $C_N$ est divisée en deux régions 52a, 52b distinctes par le sillon 50, comprenant une première région 52a de longueur $L_a$, mesurée selon la direction d'étendue X, et une deuxième région 52b de longueur $L_b$, mesurée selon la direction d'étendue X.

Les longueurs $L_a$ et $L_b$ sont, par exemple, égales l'une à l'autre.

Le contact supérieur 40 est également divisé en un premier terminal 40a s'étendant sur la première région 52a et un deuxième terminal 40b s'étendant sur la deuxième région 52b.

Le premier terminal 40a et le deuxième terminal 40b sont distincts l'un de l'autre et disjoints, de façon à pouvoir être mis en contact électrique avec deux électrodes différentes et portés à deux potentiels électriques différents.

Cela permet de mettre en oeuvre un pompage optique électrique asymétrique. Une partie de la nervure 14 constitue un milieu à gain tandis qu'une autre partie reste absorbante, ce qui permet de réaliser la fonction d'absorbant saturable comme décrit plus haut.

D'autres modes de réalisation du laser 10 sont envisageables et présentent des avantages identiques à ceux du laser 10 décrit précédemment.

Selon des modes de réalisation, la dimension $a_n$ des écartements séparant les tranchées 36 ne varie pas d'une tranchée 36 à l'autre.

Un autre paramètre, choisi parmi les largeurs $W_n$, les épaisseurs $E_n$ et les hauteurs $H_n$ des tranchées 36 varie suivant une loi de variation telle que décrite précédemment.

La variation de l'un quelconque des paramètres permet d'obtenir un réseau de tranchées 36 modulé de façon à obtenir une émission d'impulsions laser multimodes synchronisées en phase.

Selon un mode de réalisation, le guide d'ondes 16 est rectiligne et s'étend selon une direction de guidage X'.

La direction de guidage X' est perpendiculaire à la direction d'empilement Z et forme un angle de guidage $\alpha$ avec la direction d'étendue X.

L'angle de guidage $\alpha$ est, dans l'exemple présenté, nul.

Selon un mode de réalisation, l'angle $\alpha$ est non-nul, et, par exemple, compris entre - 15° et 15°.

Selon un mode de réalisation, la nervure 14 comprend un unique prolongement latéral 34, s'étendant d'un seul côté de la partie centrale 30, et un unique contact latéral 42 s'étendant sur le prolongement latéral.

Selon un mode de réalisation, les longueurs $L_a$ et $L_b$, respectivement de la première région 52a et de la deuxième région 52b, sont différentes l'une de l'autre.

Selon un mode de réalisation, la couche $C_N$ est divisée en trois ou plus parties distinctes, par une pluralité de sillons 50 comme décrits précédemment, s'étendant selon la direction transversale Y, chaque partie présentant un contact respectif. Cela permet de mettre en oeuvre un pompage optique asymétrique mieux contrôlé.

Selon un mode de réalisation, le guide d'ondes 16 présente une largeur Wg qui varie selon l'étendue du guide d'ondes 16.

La variation de la largeur Wg suit, par exemple, une loi polynomiale symétrique du type $g(x) = w_0 + w_2 x^2 + ...$ .

La variation de la largeur Wg est ajustée pour améliorer le couplage entre la nervure 14 et le guide d'ondes 16 aux différents modes de résonance.

Selon un mode de réalisation, les tranchées 36 sont définies dans les faces latérales de la cavité 15.

Les modes de réalisations décrits peuvent être combinés selon toute configuration techniquement réalisable.

## Revendications

1. Laser (10) à verrouillage de mode comprenant :

   - un substrat (12) isolant,
   - une nervure (14) s'étendant sur le substrat (12) selon une direction d'étendue (X),
   - une cavité (15) résonante pour au moins une onde électromagnétique, la cavité (15) étant définie dans le substrat (12), au droit de la nervure (14),
   - un guide d'ondes (16) défini dans le substrat (12), s'étendant selon une direction de guidage (X'),

      la nervure (14) comprenant une couche inférieure ($C_2$), une pluralité de couches intermédiaires ($C_3$ à $C_{N-1}$) et une couche supérieure ($C_N$), empilées selon une direction d'empilement (Z) orthogonale à la direction d'étendue (X),
      la cavité (15) étant propre à accueillir une pluralité de modes de résonnance équidistants en fréquence,
      la cavité (15) comprenant une pluralité de tranchées (36) ménagées dans au moins une des faces (44) de la cavité (15), les tranchées (36) s'étendant perpendiculairement à la direction d'étendue (X),
      chaque tranchée (36) présentant des paramètres, les paramètres étant :

      - une largeur ($W_n$) de la tranchée (36), mesurée selon une direction transversale (Y) orthogonale à la direction d'étendue (X) et à la direction d'empilement (Z),
      - une épaisseur ($E_n$) de la tranchée (36), mesurée selon la direction d'étendue (X),
      - une profondeur ($P_n$) de la tranchée (36), mesurée selon la direction d'empilement (Z), et
      - une dimension ($a_n$) d'un écartement séparant chaque tranchée (36) d'une tranchée (36) voisine, la dimension ($a_n$) étant mesurée selon la direction d'étendue (X),

      au moins un paramètre parmi les paramètres des tranchées (36) variant selon la direction d'étendue (X) selon une loi de variation,
      la loi de variation étant une fonction polynomiale symétrique d'ordre supérieur ou égal à quatre d'une position de la tranchée (36) selon la direction d'étendue (X).

2. Laser selon la revendication 1, dans lequel la fonction polynomiale est d'ordre quatre, et est décrite par une formule du type :

$$p_n = p(x_n) = p_0 + A x_n{}^2 + B x_n{}^4$$

   où :

   - $p_n$ est la valeur du paramètre de la tranchée (36) référencée par un indice n,
   - $x_n$ est la distance entre une tranchée (36), référencée par l'indice 0, et la tranchée (36) référencée par l'indice n,
   - $p_0$ est la valeur du paramètre de la tranchée (36) référencée par l'indice 0, et
   - A et B sont des constantes non-nulles.

3. Laser selon la revendication 2, dans lequel une valeur de A est choisie de manière à fixer une valeur d'un intervalle spectral libre de la cavité (15), une valeur de B étant choisie pour permettre d'obtenir les modes de résonance équidistants en fréquence de la cavité (15).

4. Laser selon l'une quelconque des revendications 1 à 3, dans lequel la cavité (15) présente une longueur ($L_c$) mesurée selon la direction d'étendue (X), la longueur ($L_c$) de la cavité (15) étant suffisante pour que la cavité (15) soit apte à accueillir au moins six modes de résonnance équidistants en fréquence, la longueur ($L_c$) de la cavité (15) étant notamment supérieure ou égale à 200 micromètres.

5. Laser selon l'une quelconque des revendications 1 à 4, dans lequel la couche inférieure ($C_2$) définit, selon une direction transversale (Y), des prolongements latéraux (34) s'étendant de part et d'autre des couches intermédiaires ($C_3$ à $C_{N-1}$) et de la couche supérieure ($C_N$), chaque prolongement latéral (34) recevant au moins un contact électrique (42).

6. Laser selon l'une quelconque des revendications 1 à 5, dans lequel la couche supérieure ($C_N$) comprend un sillon (50) isolant s'étendant à travers la couche supérieure ($C_N$) selon la direction transversale (Y), de manière à diviser la couche supérieure ($C_N$) en deux régions (52a, 52b) voisines selon la direction d'étendue (X), isolées électriquement l'une de l'autre, chaque région (52a, 52b) recevant un contact électrique (40a, 40b) respectif distinct.

**7.** Laser selon l'une quelconque des revendications 1 à 5, dans lequel la nervure (14) comprend également une couche absorbante ($C_1$) s'étendant en-dessous de la couche inférieure ($C_2$) selon la direction d'empilement (Z), la couche absorbante ($C_1$) comprenant un matériau absorbant saturable à au moins une fréquence de résonance de la cavité (15).

**8.** Laser selon l'une quelconque des revendications 1 à 7, dans lequel le guide d'ondes (16) est décalé par rapport à la cavité (15) et à la nervure (14), selon la direction transversale (Y).

**9.** Laser selon la revendication 7 ou 8, dans lequel le guide d'ondes présente une largeur variable le long d'une étendue du guide d'onde (16), mesurée selon une direction orthogonale à une direction d'étendue locale du guide d'onde (16).

**10.** Composant optique comprenant un laser (10) selon l'une quelconque des revendications 1 à 9.

**Patentansprüche**

**1.** Modengekoppelter Laser (10), umfassend:

- ein isolierendes Substrat (12),
- eine Rippe (14), die sich auf dem Substrat (12) gemäß einer Erstreckungsrichtung (X) erstreckt,
- einen Resonanzhohlraum (15) für mindestens eine elektromagnetische Welle, wobei der Hohlraum (15) in dem Substrat (12) gerade zur Rippe (14) definiert ist,
- einen Wellenleiter (16), der in dem Substrat (12) definiert ist und sich gemäß einer Führungsrichtung (X') erstreckt,

   wobei die Rippe (14) eine untere Schicht ($C_2$), eine Vielzahl von Zwischenschichten ($C_3$ bis $C_{N-1}$) und eine obere Schicht ($C_N$) umfasst, die gemäß einer zu der Erstreckungsrichtung (X) orthogonalen Stapelrichtung (Z) gestapelt sind,
   wobei der Hohlraum (15) geeignet ist, eine Vielzahl von frequenzmäßig äquidistanten Resonanzmoden aufzunehmen,
   wobei der Hohlraum (15) eine Vielzahl von Gräben (36) umfasst, die in mindestens einer der Flächen (44) des Hohlraums (15) ausgebildet sind, wobei sich die Gräben (36) senkrecht zu der Erstreckungsrichtung (X) erstrecken,
   wobei jeder Graben (36) Parameter aufweist, wobei die Parameter sind:

- eine Breite ($W_n$) des Grabens (36), gemessen gemäß einer Querrichtung (Y), die orthogonal zu der Erstreckungsrichtung (X) und der Stapelrichtung (Z) verläuft,
- eine Dicke ($E_n$) des Grabens (36), gemessen gemäß der Erstreckungsrichtung (X),
- eine Tiefe ($P_n$) des Grabens (36), gemessen gemäß der Stapelrichtung (Z), und
- eine Abmessung ($a_n$) eines Abstands, der jeden Graben (36) von einem benachbarten Graben (36) trennt, wobei die Abmessung ($a_n$) gemäß der Erstreckungsrichtung (X) gemessen wird,

   wobei mindestens ein Parameter von den Parametern der Gräben (36) gemäß der Erstreckungsrichtung (X) gemäß einem Variationsgesetz variiert,
   wobei das Variationsgesetz eine symmetrische Polynomfunktion einer Ordnung größer oder gleich vier einer Position des Grabens (36) gemäß der Erstreckungsrichtung (X) ist.

**2.** Laser nach Anspruch 1, wobei die Polynomfunktion vierter Ordnung ist und beschrieben wird durch eine Formel des Typs:

$$p_n = p(x_n) = p_0 + Ax_n^2 + Bx_n^4$$

wobei:

- $p_n$ der Parameterwert des Grabens (36) ist, der durch einen Index n referenziert ist,
- $x_n$ der Abstand zwischen einem Graben (36) ist, der durch den Index 0 referenziert ist, und dem Graben (36), der durch den Index n referenziert ist,
- $p_0$ der Parameterwert des Grabens (36) ist, der durch den Index 0 referenziert ist, und
- A und B Nicht-Null-Konstanten sind.

**3.** Laser nach Anspruch 2, wobei ein Wert von A so gewählt ist, dass ein Wert eines freien Spektralintervalls des Hohlraums (15) festgelegt wird, wobei ein Wert von B gewählt ist, um zu gestatten, die frequenzmäßig äquidistanten Resonanzmoden des Hohlraums (15) zu erhalten.

**4.** Laser nach einem der Ansprüche 1 bis 3, wobei der Hohlraum (15) eine Länge ($L_c$), gemessen gemäß der Erstreckungsrichtung (X), aufweist, wobei die Länge ($L_c$) des Hohlraums (15) ausreichend ist, damit der Hohlraum (15) imstande ist, mindestens sechs frequenzmäßig äquidistante Resonanzmoden aufzunehmen, wobei die Länge ($L_c$) des Hohlraums (15) insbesondere größer oder gleich 200 Mikrometer ist.

5. Laser nach einem der Ansprüche 1 bis 4, wobei die untere Schicht ($C_2$) gemäß einer Querrichtung (Y) seitliche Verlängerungen (34) definiert, die sich beiderseits der Zwischenschichten ($C_3$ bis $C_{N-1}$) und der oberen Schicht ($C_N$) erstrecken, wobei jede seitliche Verlängerung (34) mindestens einen elektrischen Kontakt (42) aufnimmt.

6. Laser nach einem der Ansprüche 1 bis 5, wobei die obere Schicht ($C_N$) eine isolierende Rille (50) umfasst, die sich durch die obere Schicht ($C_N$) gemäß der Querrichtung (Y) erstreckt, so dass die obere Schicht ($C_N$) in zwei benachbarte Bereiche (52a, 52b) gemäß der Erstreckungsrichtung (X) unterteilt wird, die elektrisch voneinander isoliert sind, wobei jeder Bereich (52a, 52b) einen jeweiligen verschiedenen elektrischen Kontakt (40a, 40b) aufnimmt.

7. Laser nach einem der Ansprüche 1 bis 5, wobei die Rippe (14) ebenfalls eine absorbierende Schicht ($C_1$) umfasst, die sich unterhalb der unteren Schicht ($C_2$) gemäß der Stapelrichtung (Z) erstreckt, wobei die absorbierende Schicht ($C_1$) ein absorbierendes Material umfasst, das bei mindestens einer Resonanzfrequenz des Hohlraums (15) sättigbar ist.

8. Laser nach einem der Ansprüche 1 bis 7, wobei der Wellenleiter (16) im Verhältnis zu dem Hohlraum (15) und zu der Rippe (14) gemäß der Querrichtung (Y) versetzt ist.

9. Laser nach Anspruch 7 oder 8, wobei der Wellenleiter eine variable Breite entlang einer Erstreckung des Wellenleiters (16), gemessen gemäß einer Richtung, die orthogonal zu einer lokalen Erstreckungsrichtung des Wellenleiters (16) ist, aufweist.

10. Optische Komponente, umfassend einen Laser (10) nach einem der Ansprüche 1 bis 9.

**Claims**

1. A mode-locked laser (10) comprising:

   - an insulating substrate (12),
   - a rib (14) extending over the substrate (12) in an extension direction (X),
   - a resonant cavity (15) for at least one electromagnetic wave, the cavity (15) being defined in the substrate (12), in line with the rib (14),
   - a wave guide (16) defined in the substrate (12), extending in a guiding direction (X'),

   the rib (14) comprising a lower layer ($C_2$), a plurality of intermediate layers ($C_3$ to $C_{N-1}$)

and an upper layer ($C_N$), stacked in a stacking direction (Z) orthogonal to the direction of extent (X),

the cavity (15) being able to accommodate a plurality of resonance modes equidistant in frequency,

the cavity (15) comprising a plurality of trenches (36) formed in at least one of the faces (44) of the cavity (15), the trenches (36) extending perpendicularly to the direction of extent (X),

each trench (36) having parameters, the parameters being:

- a width ($W_n$) of the trench (36), measured in a transverse direction (Y) orthogonal to the direction of extent (X) and to the direction of stacking (Z),
- a thickness ($E_n$) of the trench (36), measured in the direction of extent (X),
- a depth ($P_n$) of the trench (36), measured in the stacking direction (Z), and
- a dimension ($a_n$) of a spacing separating each trench (36) from an adjacent trench (36), the dimension ($a_n$) being measured in the direction of extent (X),

   at least one of the parameters of the trenches (36) varying along the direction of extent (X) according to a law of variation,
   the law of variation being a symmetrical polynomial function of order greater than or equal to four of a position of the trench (36) along the direction of extent (X).

2. Laser according to claim 1, in which the polynomial function is of order four, and is described by a formula of the type:

$$p_n = p(x_n) = p_0 + Ax_n^2 + Bx_n^4$$

where:

   - $p_n$ is the parameter value of the trench (36) referenced by an index n,
   - $x_n$ is the distance between a trench (36), referenced by index 0, and the trench (36) referenced by index n,
   - $p_0$ is the parameter value of the trench (36) referenced by index 0, and
   - A and B are non-zero constants.

3. Laser according to claim 2, in which a value of A is chosen so as to fix a value of a free spectral interval of the cavity (15), a value of B being chosen so as to make it possible to obtain the resonance modes equidistant in frequency of the cavity (15).

4. Laser according to any one of claims 1 to 3, in which the cavity (15) has a length ($L_c$) measured in the direction of extension (X), the length ($L_c$) of the cavity (15) being sufficient for the cavity (15) is able to accommodate at least six resonance modes equidistant in frequency, the length ($L_c$) of the cavity (15) being in particular greater than or equal to 200 micrometres.

5. Laser according to any one of claims 1 to 4, in which the lower layer ($C_2$) defines, in a transverse direction (Y), lateral extensions (34) extending on either side of the intermediate layers ($C_3$ to $C_{N-1}$) and the upper layer ($C_N$), each lateral extension (34) receiving at least one electrical contact (42).

6. Laser according to any one of claims 1 to 5, wherein the top layer ($C_N$) comprises an insulating trench (50) extending through the top layer ($C_N$) in the transverse direction (Y), so as to dividing the top layer ($C_N$) into two regions (52a, 52b) adjacent in the direction of extension (X), electrically insulated from each other, each region (52a, 52b) receiving a separate respective electrical contact (40a, 40b).

7. Laser according to any one of claims 1 to 5, wherein the rib (14) also comprises an absorber layer ($C_1$) extending below the lower layer ($C_2$) in the stacking direction (Z), the absorber layer ($C_1$) comprising an absorber material saturable at at least one resonant frequency of the cavity (15).

8. Laser according to any one of claims 1 to 7, in which the wave guide (16) is offset relative to the cavity (15) and the rib (14) in the transverse direction (Y).

9. Laser according to claim 7 or 8, wherein the wave guide has a variable width along an extent of the wave guide (16), measured in a direction orthogonal to a local extent direction of the wave guide (16).

10. Optical component comprising a laser (10) according to any one of claims 1 to 9.

EP 4 055 671 B1

**FIG.1**

**FIG.2**

EP 4 055 671 B1

FIG.3

**FIG.4**

EP 4 055 671 B1

FIG.5

EP 4 055 671 B1

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **SANTIS ; CHRISTOS THEODOROS et al.** High-coherence semiconductor lasers based on intégral high-Q resonators in hybrid Si/III-V platforms. *Proceedings of the National Academy of Sciences,* 2014, vol. 111 (8), 2879-2884